# EUROPEAN PATENT SPECIFICATION

(11) **EP 3 413 076 B1**
(45) Date of publication and mention of the grant of the patent: **26.01.2022**
(21) Application number: 17179814.3
(22) Date of filing: 05.07.2017
(51) Int. Cl.: G01R 33/567

(54) **MRI INVOLVING THE GENERATION OF A PHYSIOLOGICAL MOTION SIGNAL USING A PILOT TONE NAVIGATOR**
MRI MIT ERZEUGUNG EINES PHYSIOLOGISCHEN BEWEGUNGSSIGNALS UNTER VERWENDUNG EINES PILOTTON-NAVIGATORS
IRM IMPLIQUANT LA GÉNÉRATION D'UN SIGNAL DE MOUVEMENT PHYSIOLOGIQUE UTILISANT UN NAVIGATEUR DE TONALITÉ PILOTE

(30) Priority: 08.06.2017 DE 102017209708; 08.06.2017 DE 102017209710
(43) Date of publication of application: 12.12.2018
(73) Proprietor: Siemens Healthcare GmbH, 91052 Erlangen (DE)
(72) Inventor: Bacher, Mario, 90441 Nürnberg (DE); Speier, Peter, 91056 Erlangen (DE)

(56) References cited:
- US-A1- 2017 160 364
- JAESCHKE SHF ET AL: "Contact-free Cardiac Motion Estimation using the Scatter of a Parallel Transmit Coil at 7T MRI", PROCEEDINGS OF THE INTERNATIONAL SOCIETY FOR MAGNETIC RESONANCE IN MEDICINE, ISMRM, 25TH ANNUAL MEETING AND EXHIBITION, HONOLULU, HAWAII, USA, 22-27 APRIL 2017, no. 3262, 7 April 2017 (2017-04-07), page 3262, XP040690830,
- PASCAL SPINCEMAILLE ET AL: "Kalman filtering for real-time navigator processing", MAGNETIC RESONANCE IN MEDICINE., vol. 60, no. 1, 1 July 2008 (2008-07-01), pages 158-168, XP055447072, US ISSN: 0740-3194, DOI: 10.1002/mrm.21649
- GRAESSLIN I ET AL: "Advancements in Contact-Free Respiration Monitoring using RF Pick-up coils", PROCEEDINGS OF THE INTERNATIONAL SOCIETY FOR MAGNETIC RESONANCE IN MEDICINE, ISMRM, 18TH SCIENTIFIC MEETING AND EXHIBITION, STOCKHOLM, SWEDEN, 1-7 MAY 2010, 17 April 2010 (2010-04-17), page 3045, XP040614492,

## Description

The present invention describes a method for generating a movement signal of a part of the human or animal body, a computer program product as well as a digital storage medium and control unit.

Patient movement or motion during a diagnostic examination or scan of medical data, in particular during radiological imaging, often causes artefacts in the acquired images. Especially Magnetic Resonance (MR) imaging is relatively slow, so that respiratory and cardiac movement will occur during the scan. If the movement is known, the data acquisition can be triggered to a particular phase in the cyclical movement, or the acquired data can be corrected. It is therefore common practice to acquire an ECG (electrocardiogram) of the patient during radiological imaging in order to trigger the data acquisition to a particular phase in the cardiac cycle. For example documents US 8116856 B2 or US 7899521 B2 describe an arrangement for recording ECG signals and document US 7702376 B2 describes a method for ECG-triggering a measuring sequence of a magnetic resonance device. However, taking an ECG during an MR scan presents difficulties, in particular because of the high magnetic fields, which may cause interferences in the ECG leads. Therefore, one seeks other methods of detecting patient movement, in particular cardiac movement, during a radiological scan.

An innovative way for inferring information about respiratory motion or patient motion during patient acquisitions in MR measurements, termed "Pilot Tone (PT) Navigation" has been described in post-published document DE 10 2015 224 162

The basic principle is to measure the variation induced by physiological motion by means of a coherent or continuous external frequency signal received by the local coil elements outside the receive bandwidth of the actually scanned MR field of view, but within the range of the oversampling bandwidth which is acquired during every readout.

Pfanner et al. describe a similar method based on continuous wave radar, operating in the 860MHz band [9,10] and were able to clearly detect and extract cardiac motion from the received signal. However, they found the signal to be highly dependent on receiver placement, likely due to the short wavelength (35cm in air, less in biological tissues by a factor of about 7 [18]). The heart moves during the respiratory cycle and at this small wavelength, this movement is resolved as well. The Pilot Tone method operates at much larger wavelengths of 4.7m or 2.3m in air at 1.5T and 3T, respectively, and therefore cannot resolve small movements. Instead, the PT signal is primarily modulated by the volumetric contraction of the heart.

The ability of Pilot Tone navigation to detect physiological motion was previously shown for the respiratory component in Schroeder et al., Wetzl et al. [14, 15] and for the cardiac component in Schroeder et al. [16]. The data base in [16] was limited to a handful of measurements with one volunteer, therefore no conclusions about robustness of the method and required processing to stabilize the signal in various situations could be derived.

Jaeschke et al. (Document D1) in their paper "Contact-free Cardiac Motion Estimation using the Scatter of a Parallel Transmit Coil at 7T MRI", Proceedings of the International Society for Magnetic Resonance in Medicine, ISMRM, 25th Annual Meeting, Honolulu, USA, 2017, 22-27 April 2017, p. 3262, present a method that uses directional couplers from the SAR monitoring system and an 8-channel transmit RF coil to measure the reflection coefficients from the RF coil simultaneously. Cardiac motion is determined with Gaussian shaped RF-monitoring pulses and an independent component analysis.

It is an object of the present invention to present a method for robust and real-time processing of the Pilot Tone signal in order to reliably extract the cardiac movement signal, and separate it from other motion and signal components. It is another object of the invention to extract synchronization information from the Pilot Tone signal, i.e. the information needed for prospective triggering and retrospective gating of the imaging data.

The object is solved by a method according to claim 1, by a computer program product according to claim 12, a digital storage medium according to claim 13, and a control unit according to claim 14 .

The invention is directed to a method for generating a movement signal of a part of the human or animal body, of which at least a portion is undergoing a cyclical movement, in particular a cardiac and/or respiratory movement, the method comprising the steps:
a. Providing a Pilot Tone signal acquired , during a magnetic resonance scan from the body part by a magnetic resonance receiver coil arrangement comprising several channels, wherein the Pilot Tone signal is a frequency signal outside the receive bandwidth of the Magnetic Resonance scan of the body part and comprises several signal components associated with the several channels;
b. From a calibration portion of the Pilot Tone signal , calculating a demixing matrix by means of an Independent Component Analysis (ICA) algorithm, wherein the demixing matrix calculates the independent components from the several signal components,
c. Selecting the independent component(s) corresponding to at least one particular movement type, in particular the cardiac movement,
d. Applying the demixing matrix to the further portions of the Pilot Tone signal to obtain at least one movement signal representing the one particular movement type, in particular the cardiac movement,
e. Applying an adaptive or stochastic or model-based filter to the at least one movement signal representing the one particular movement type, in particular the cardiac movement, to obtain a filtered movement signal.

The method allows to reliably extract the cardiac motion signal (which is then the movement signal representing one particular movement type) with the help of a Pilot Tone measurement system, and separates the cardiac motion signal from other motions and signal components.

The method is preferably carried out during a scan of medical data, in particular medical image data, from the part of the human or animal body (body part), in particular during a magnetic resonance scan. The method can be performed during the whole time of the scan or only during one or several stages of the scan.

The invention provides a method for filtering and analysis of curve properties, and/or for a segmentation of the movement signal representing the cardiac movement (in the following also called cardiac component or cardiac component trace), either in real-time or retrospectively. The inventive method provides a basis for extracting features from the cardiac component, which may be used e.g. for triggering the acquisition of the scan of medical data, in particular for triggering a magnetic resonance imaging or spectroscopy scan.

The invention has the advantage of providing reliable ECG-free cardiac imaging. In comparison with known ECG-based imaging methods, the invention can be implemented at lower costs. Further, since no leads have to be attached to the patient, there is better patient comfort and the preparation time for the radiological examination is reduced. In addition, the method is more reliable than ECG, because there is no interference between the Pilot Tone signal and the MR signal, and thus provides increased triggering reliability.

Contrary to ECG-based triggering, the inventive method allows a synchronization of the scan of medical data to arbitrary cardiac phases.

The proposed method may be used outside of MR in connection with other imaging or therapy modalities such as PET, SPECT, X-Ray, CT, etc., if the transmitting and receiving hardware for the Pilot Tone signal, i.e. a receiving coil arrangement, is built as a stand-alone device, independent of the MR scanner hardware.

The part of the human or animal body (body part), of which at least a portion is undergoing a cyclical movement, is usually the organ or body part undergoing a diagnostic examination such as a scan of medical image data, in particular a heart, blood vessel, thorax or lung, or other organ affected by motion such as cardiac movement. The scan of medical data or image data is preferably a magnetic resonance (MR) scan, but may be another modality, such as Positron Emission Tomography (PET), X-Ray, Single Photon Emission Computed Tomography (SPECT) or Computed Tomography (CT). "Cyclical movement" means that the movement is repeating itself, such as respiration or cardiac movement. The movement must not be completely rhythmic, as would be impossible for physiological movements; in fact the method may be applied to patients with arrhythmia or irregular respiration as well. The method may also be applied in non-cyclic movements, such as respiratory motion when breathholds are used during the scan, or when the breathing is arrhythmic due to medical conditions.

The Pilot Tone (PT) signal is a frequency signal received by a magnetic resonance receiver coil arrangement, usually a standard MR local coil, which has several channels, outside the receive bandwidth of an MR scan of the body part. The PT signal is usually generated by an independent continuous-wave radio frequency (RF) source. The frequency of the emitted PT signal may be between about 20 to 200 kHz away from the centre frequency of the Magnetic Resonance receiver coil arrangement, i.e. of the MR scanner, to avoid interference with the desired Magnetic Resonance imaging (MRI) data, but still within the application imaging bandwidth. The centre frequency is e.g. 123.2 MHz at 3T. In other embodiments, the frequency of the emitted PT signal is outside the application imaging bandwidth but still inside the range digitized in the receiver. In that case, the frequency could be in the range of 1-5MHz, ideally at ½ of the Nyquist frequency.

Since the frequency range of the PT signal does not cover the Larmor frequency, the received PT signal is unaffected by MR effects. However, it is modulated by the movement of the body part, since this movement influences the signal transmission between the source and the receiver coil arrangement, and may affect the load and therefore the receive characteristics of the receiver coil arrangement.

An MR receiver coil arrangement usually comprises several elements, e.g. in the form of a coil array, each acquiring a separate signal component. In other words, the PT signal comprises several, possibly complex, signal components received from several channels. Preferably, the invention uses 4 to 128, preferably 8 to 64 receiver channels, as used in modern MR receiver coil arrangements. Different types of movement usually affect the channels to different degrees, depending e.g. on the orientation and position of the moving body part with respect to the coil element. It is therefore necessary to combine the signal components of the PT signal in an intelligent way in order to extract particular movement types such as cardiac movement and/or respiratory movement.

A "Movement type" means one of several motion types happening in the body part at the same time, e.g. cardiac movement, respiratory movement, and other voluntary or involuntary patient movement, e.g. turning of head, moving of hand or legs etc.. The method of this invention can be particularly applied to extract the cardiac movement, but may be used to extract any other movement type as well. A "cardiac movement" means any movement caused by the regular contraction of the heart muscles, be it in the heart itself or in other body parts affected by it, in particular by means of arterial blood vessels.

Preferably, respiratory motion is detected alongside cardiac motion. Thus, even if the respiratory motion of the heart introduces some small error, e.g. at higher field strengths where the Pilot Tones signal must be of higher frequency (298MHz at 7T), this error could be accounted for knowing the respiratory signal. The respiratory signal/component could be detected in the same way as the cardiac component, i.e. as an independent component of the Pilot Tone signal. This could be done by Independent Component Analysis (ICA), as described in detail below. Alternatively, any errors introduced by respiratory motion could be corrected with a respiration resolved training, i.e., instead of applying and training a single template or a single adaptive or stochastic or model-based filter to the signal representing the cardiac movement, a series of templates or filters is trained, which vary with the respiratory phase. Thus, these different filters are applied to the signal representing the cardiac movement, depending on the respiratory phase.

The Pilot Tone signal is usually acquired during the entire scan of medical data, in particular a magnetic resonance scan, and thus the inventive method may be used to generate a movement signal over the entire scan of medical data, or at least relevant parts thereof.

The Pilot Tone signal usually undergoes a calibration and possibly other pre-processing steps, examples of which shall be described below. The present invention focusses on the next processing step, in which a movement signal relating to one particular movement is separated from the PT signal components, and the subsequent filter step allowing to detect certain features in the movement signal.

As part of the processing step, a demixing matrix is calculated from a calibration portion of the Pilot Tone signal by an independent component analysis (ICA). The ICA is performed on the several signal components corresponding to the several channels. A demixing matrix generally separates the independent components - which here correspond to different movement types - from several signal components. In this case, the demixing matrix, which is applied to the further portions of the Pilot Tone signal, is a demixing matrix when extracting several movement types, but becomes a demixing vector when only one movement type (independent component) is extracted. Thus, in this document, the term "demixing matrix" shall cover also "demixing vector", depending on whether one or several movement types are extracted. The demixing matrix, when applied to the Pilot Tone signal, will separate at least one particular movement type, among them preferably the cardiac component, from the several signal components. Depending on the implementation of the ICA, this demixing matrix can be either complex or real-valued.

In preferred embodiments, ICA is first used to extract several independent components from a calibration portion of the Pilot Tone signal, and when the independent component(s) corresponding to the desired movement types have been selected, a demixing matrix or vector that extracts these movement type(s) is applied to the further portions of the Pilot Tone signal, preferably in real time. When several movement types are to be extracted, applying the demixing matrix may result in several movement signals, each representing one particular movement type.

The "calibration portion" of the Pilot Tone signal is preferably a short portion covering only a few (e.g. 1 to 20) heart beats acquired before or at the beginning of the scan of medical data.

Alternatively, e.g. where the movement signal is to be applied retrospectively, the calibration portion may cover the complete or a part of the Pilot Tone signal, in particular the complete Pilot Tone signal acquired during the scan. In other words, ICA can be done either retrospectively on the whole signal acquired during the scan or, for real-time triggering applications, following a short calibration scan. The computed demixing matrix can then be used to unmix incoming data in real-time.

Since any motion by the patient affects the load of the coil elements in a potentially unpredictable way, the following steps relating to the ICA are important to extract the signal components of the desired movement type (in particular cardiac motion) from the overall Pilot Tone signal. Any unwanted patient motion like turning the head, feet, etc. may affect the overall signal by adding offsets to the coil elements. The goal is to compute an optimal linear channel combination, which would weigh the contributions of the different channel elements accordingly, i.e., suppressing contributions from unwanted patient motion while maximizing sensitivity to one particular movement type, e.g. cardiac motion.

One way to obtain an ideal channel combination is to apply Independent Component Analysis (ICA) [1] either on real valued or complex data. ICA is based on the assumption that individual components of a multivariate signal are non-Gaussian and that they are statistically independent from each other. ICA finds the independent components by maximizing the independence of the estimated components. Statistical independence can generally be achieved by either minimizing the mutual information or by maximizing the non-gaussianity. Thus, solving the ICA can be formulated as a minimization or maximization problem, depending on the measure of statistical independence used and solved by a variety of minimization techniques, e.g. gradient descent methods or the Gauss-Newton algorithm and its variants.

Several algorithms exist for performing ICA, either in the complex or real domain, e.g. Infomax [11], FastICA [12] or Entropy-Bound-Minimization (EBM) and Entropy-Rate-Bound-Minimization (ERBM) [13]. As mentioned above, the respiratory motion of the heart may be an issue at higher field strengths, especially at 7T. However, ICA may be able to separate this respiratory movement component from the component generated by the pumping action of the heart.

The demixing matrix can be computed only once, e.g. in the beginning of the scan of medical data. However, unwanted motion of the patient after the demixing matrix has been computed may result in a degradation of separation quality, especially during longer scans. In this case, the demixing matrix can be updated iteratively in either regular or irregular intervals during the scan, for example whenever an unwanted patient movement has been detected. Thus, the step of calculating a demixing matrix may be repeated in either regular or irregular intervals during the scan. The recalculation might be triggered by analysing the PT or MR signal.

ICA generally cannot identify the actual number of source signals (independent components), their ordering and their scaling (including sign). Therefore, the choice of the right independent component, i.e. the component containing cardiac motion, is preferably done either manually by the operator, or by computing quality criteria from the independent components, such as the signal energy in the frequency band which is characteristic for the particular movement type. Selected manually means that a user or an operator can select the independent component with the help of a user interface. The quality criterion may be the signal energy in the cardiac motion band (0.5-6Hz) over signal energy in other frequency bands, correlation to a given, *a priori* template of a typical cardiac motion signal, wavelet analysis with a suitable wavelet, or correlation to an imaging navigator signal acquired during a short calibration scan. Thus, the independent component corresponding to the cardiac movement may be selected by computing quality criteria such as mentioned above for each independent component calculated by the demixing matrix, and selecting that independent component whose quality criterion is closest to that of the desired movement type. For example, the independent component with has most signal energy in the cardiac frequency band is selected.

Once the demixing matrix has been obtained, e.g. using a short calibration scan preceding the scan of medical data, followed by Independent Component Analysis, as described above, incoming data like the further portions of the Pilot Tone signal, or the complete or part of the Pilot Tone signal acquired during the scan of medical data, is multiplied with the demixing matrix/vector. By selecting the correct independent component, a movement signal relating to one particular movement type, in particular cardiac movement, is obtained.

In a next step, the cardiac component is further processed by filtering, preferably in real-time, for example to obtain triggers.

Accordingly, an adaptive or stochastic or model-based filter is applied to the signal representing one particular movement type, in particular the cardiac movement (in the following referred to as cardiac component), to obtain a filtered movement signal. The Filter can be e.g. a Kalman filter, an extended Kalman filter, or a switched Kalman Filter.

The filter preferably has to fulfil the following criteria: If the filtered movement signal is to be used in triggering, the filter may not introduce significant delay. Therefore, advanced filters like adaptive or stochastic or model-based filters are necessary. It is further preferred that the filter not only suppresses noise of the cardiac component, but should also provide information about the relevant trigger points. This is relevant in particular for cyclical movements like the cardiac movement, where it may be desired to trigger a scan of medical data to one particular physiological phase of the cyclical movement, such as mid-diastole, end-diastole etc. Since the movement signal is obtained by a completely different mechanism than an ECG signal, it does not have the distinctive R-wave, which can easily be used as trigger point. Rather, the movement signal has to be analysed to determine the physiological phases. However, this cannot be done retrospectively, if the movement signal is to be used in real-time applications for triggering. Therefore, in preferred embodiments of the invention, the filter already applies a segmentation, in particular a model-based segmentation. "Segmentation" means that the physiological phases (such as diastole, systole) are assigned to the corresponding portions of the movement signal.

In preferred embodiments, the filter not only denoises the movement signal, but already assigns segments or specific points of the movement signal to the respective phases of the movement signal, in particular the cardiac component.

In a preferred embodiment, the adaptive or stochastic or model-based filter is first trained or adapted to the selected independent component, e.g. the cardiac component, in particular the cardiac component derived from the calibration portion. Thus, the calibration portion of the Pilot Tone signal may be used also to configure the filter, since the filter may during this training phase generate or adapt a model of the movement signal to the actual Pilot Tone signal acquired in that particular scan.

In other words, segmentation of the cardiac component enables triggering e.g. on the start/end of distinct cardiac phases, but often relies on an *a priori* model of the cardiac cycle in either the time and/or frequency domain. In addition, model based segmentation is robust against measurement noise and may enable triggering on any, arbitrary points in the cardiac cycle. In the absence of severe arrhythmia, model based methods may also be able to predict cardiac activity beyond the current state. Therefore, model-based or stochastic filters are preferably applied to the movement signal.

Preferably, the filter is a Kalman Filter, or an Extended Kalman filter, or is a Switched/Switching Kalman Filter, wherein the Switching Kalman Filter switches between several models during various phases of the cyclical movement. Kalman filtering, also known as linear quadratic estimation (LQE), is an algorithm algorithmalgorithm that uses a series of measurements observed over time, containing statistical noise and other inaccuracies, and produces estimates of unknown variables that tend to be more accurate than those based on a single measurement alone, by using Bayesian inference and estimating a joint probability distribution over the variables for each timeframe. Thus, the Kalman filter provides, on the basis of the past measurements, e.g. the calibration portion, for each filtered data point a probably correct data point. The Switched Kalman filter may also include information on the physiological phase of the data point, i.e. may already perform segmentation. The Kalman, Extended Kalman and Switched/Switching Kalman filter make us of prior information trained on actual data. Thus, these and other model-based filters make use of a model of the movement signal.

Once such a model has been generated, e.g. by analysis of the cardiac component trace acquired during the calibration phase, segmentation can be achieved by various methods, such as Hidden Markov Models [8] or Switched Kalman Filters. These methods may also be used retrospectively to obtain segmentations of the cardiac component.

The underlying model for implementations using the (Extended) Kalman Filter/Smoother may be generated either in the frequency and/or time domain. Thus, the adaptive or stochastic or model-based filter may be trained to the selected independent component in the frequency and/or in the time domain. In the frequency domain, a possible model can be generated by analyzing the spectrum of the cardiac component acquired in the processing step, or on the movement signal or the cardiac component from the calibration portion of the Pilot Tone signal.

The cardiac component is only quasiperiodic, especially in patients with arrhythmias, thus each frequency component (amplitude and phase) is preferably modelled and tracked as a function of time. Several algorithms exist to implement the multiharmonic frequency-tracking Extended Kalman Filter (EKF)/Smoother, e.g. those described in [18]. Usually, up to three harmonics to the base heart rate can be resolved and amplitude and phase information can be extracted. Using Fourier-synthesis, a time-domain model can then be calculated and fed to an Extended Kalman Filter.

Thus, in a preferred embodiment the adaptive or stochastic or model-based filter is based on up to three harmonics of the base rate of the cyclic movement, in particular the cardiac movement.

Where the model is generated in the time domain, in a first embodiment a time-domain model may be constructed based on biomechanical data of the heart. An Extended Kalman Filter then continuously fits incoming date from the cardiac component to this model. Using this approach, the Extended Kalman Filter is able to track at least some changes in heart frequency. Alternatively, in patients with severe arrhythmia, several models can be trained and switched depending on the incoming data.

In another embodiment, the time-domain representation of the cardiac component relating to one cardiac cycle (e.g. acquired during the calibration portion) can be decomposed into several segments. A time-domain model can then be constructed as a piecewise function serving as the basis for either Hidden-Markov based methods or a Switched Kalman Filter. The choice of segments can be arbitrary, or based on the underlying physiology.

In some embodiment, the adaptive or stochastic or model-based filter uses a model which incorporates physiological information about the cyclic movement, in particular cardiac movement. Thus, the model may be based on a pre-configured model, which is however preferably adapted to the actual movement signal received during the scan of medical data. Thus, in a preferred embodiment the adaptive or stochastic or model-based filter uses a Hidden Markov Model (HMM) or Switched Kalman filter (SKF), wherein the Switched Kalman filter may be seen as an extension to the Hidden Markov Model.

In order to use the movement signal for triggering or post-processing the data acquired during the scan of medical data, the filtered movement signal is preferably segmented into two or more sections corresponding to two or more physiological phases of the cyclical movement. For example, the movement of a heart is segmented into diastolic phase and systolic phase, which repeat constantly. By segmentation, sections can be extracted from the filtered movement signal to describe physiological phases of the cyclical movement of a body part.

As described above, in a preferred embodiments the adaptive or stochastic or model-based filter automatically segments the movement signal into two or more sections corresponding to two or more physiological phases of the cyclical movement, in particular to the phases of the cardiac movement such as systole and diastole. "Automatically segments" means that the segmentation of the movement signals is performed without user input and is preferably done by the filter operation. Thus, the filter preferably identifies sections or points of interest of the movement signal of the cyclical movement and allocates the physiological phases of the cyclical movement to the identified sections or points of interest.

Preferably, to generate delay-free triggering points, advanced filters are implemented, e.g. adaptive filters like Least Mean Squares (LMS) [5] or the (Extended) Kalman Filter/Smoother [6, 7] or HMM or SKF. The Least Mean Squares filter uses any form of a stochastic gradient descent method.

In alternative embodiments, where no HMM or SKF or similar advanced filter is applied, the first and/or second derivative of the filtered movement signal may be calculated and in particular analysed to extract time points used for triggering or post-processing. In this case, filter which at least denoises or smoothes the movement signal representing the particular movement type is applied.

Accordingly, in preferred embodiments of the invention, the time points used for triggering a scan of medical data from the part of the human or animal body, or for post-processing a scan of medical data performed during the acquisition of the Pilot Tone signal, are extracted from the filtered movement signal. Preferably they are based on properties of the curve or on parameters of the stochastic or adaptive or model-based filter. In preferred embodiments, the time points used for triggering or post-processing can be directly derived from the stochastic or adaptive or model-based filter, once it has been trained. For example, the time points could be related to the switching times of a Switched Kalman Filter, or they could be derivable from the model/template underlying the filter. In other embodiments, the time points used for triggering could be derived from analysing the (smoothed) cardiac component, e.g. detecting minima, maxima etc., possibly also in the first and/or second derivative, and explained in more detail below.

The time points used for triggering can be used in the same scan of medical data in which they have been acquired. E.g. a calibration portion of the Pilot Tone signal is acquired, and a selection of triggering points is made (e.g. by a user). Then the scan of medical data, e.g. MR-scan, starts using the selected triggering time points, which can be optimized to the objective of the MR-scan.

Possible useful trigger points are e.g. max(abs(1st derivative)) = max velocity, or max(abs(2nd derivative)) = max acceleration or the minimum/maximum of the cardiac component trace. These points are easily obtained from the smoothed cardiac component trace and correspond to interesting features in the cardiac cycle like the early systolic and diastolic motion phases. Trigger points approximating the ECGs R-peak may be obtained by threshold based triggering using the mid-diastolic amplitude as an indicator.

Preferably, the steps of applying the demixing matrix and/or applying the adaptive or stochastic or model-based filter are performed such that no delay is introduced between the filtered movement signal and any further signal, in particular a signal comprising magnetic resonance data, acquired at the same time as the Pilot Tone signal from the body part.

The term "no delay" means that the delay is preferably kept to a minimum, preferably between 0-10ms and more preferred less than 1ms, so that the filtered movement signal is effectively generated in real time. Thus, it can be used for triggering a scan of medical data, e.g. an MR examination of the moving part of the human or animal body, such as the heart.

When no real-time functionality is needed, simple forward-backward filtering using either FIR or IIR digital filters in the time-domain or frequency-domain filtering on the cardiac component is sufficient to generate a filtered movement signal (also called "trace") on which feature detection algorithms (such as the above-described adaptive or stochastic or model-based filters) can be applied. "Forward-backward filtering" is a filter method which ensures that the filtered movement signal is not shifted in time by the filter, so there is no delay between the images acquired during the scan of medical image data and the movement signal derived from the Pilot Tone signal (even if they are not processed in real time). Since the filter does not have to operate in real time, filters of significantly higher order and with a lower cutoff-frequency can be used while maintaining zero delay through forward-backward filtering. This also effectively doubles the filter order. Alternatively, zero lag filtering in the frequency domain can be applied. The filter may serve to denoise/smooth the movement signal.

Accordingly, in an embodiment of the invention, instead of the stochastic or model-based filter, forward-backward filtering using in particular FIR or IIR digital filters is performed on the movement signal.

Prior to the calculation of the demixing matrix, the Pilot Tone signal may be (pre-)processed, as described in the following:
In order to reduce noise, the PT signal can optionally be down-sampled to a new sampling frequency that is sufficient to capture cardiac dynamics, preferably to 50 to 300 Hz, e.g. 180Hz. This frequency is chosen so that the delay introduced by filtering during down-sampling is not too long. The choice of down-sampling rate is dependent on the image acquisition rate. For cardiac imaging, a sampling frequency of around 250-400Hz is typical. Thus, preferably the Pilot Tone signal is down-sampled prior to the calculation of the demixing matrix and/or prior to the application of the demixing matrix to the further portions of the Pilot Tone signal

To avoid aliasing of high-frequency noise, the signal is preferably low pass filtered prior to down sampling. For real-time triggering applications, the down sampling factor and filter order are limited by the maximum acceptable trigger delay. In this case, the new sampling rate must still be sufficient to ensure precise triggering and the delay introduced by digital filtering (FIR or IIR structure) must be low.

Instead of low pass filters, band pass filters can be used to suppress the respiratory signal as well, reducing the expected number of independent components.

A reasonable frequency range for heart rate in adult humans is about 0.8Hz - 3Hz. In the cardiac component signal, usually the first and in some cases the 2nd harmonic can be observed, therefore an upper cut-off frequency of about 6-9Hz is necessary for the low pass or band pass filter. For retrospective applications, filters of significantly higher order and with a lower cutoff-frequency can be used.

Thus, preferably the Pilot Tone signal is low-pass filtered prior to the calculation of the demixing matrix and/or prior to the application of the demixing matrix to the further portions of the Pilot Tone signal

In preferred embodiments, the phases of all channels are then normalized to a reference phase of a selected channel and only relative phase offsets to this reference are further considered. This removes potential phase drift and wrapping problems in some channels. Phase normalization is achieved by multiplying with the complex conjugate of the phase of the sample from the reference channel. The normalized complex navigator samples are then further processed to separate the motion components.

In order to reduce the complexity of the ICA problem, further pre-processing steps are preferably performed before the calculation of the demixing matrix, or before the ICA algorithm. These may include centering (subtracting the mean so that the resulting signals are zero-mean), whitening/sphering to ensure that all signals have unit variance and are uncorrelated, i.e. for a given (n x m) matrix x, where n is the number of samples and m is the number of channels, Cov(x) = E{xxT}=I, with I the identity matrix, and dimensionality reduction.

Whitening can be achieved by Principal Component Analysis (PCA) [2] based on either eigenvalue or singular value decomposition [3, 4]. Dimensionality reduction can be performed by using only the k largest principal components / singular values, where k is smaller than the number of channels.

Thus, in advantageous embodiments, the method comprises the further step of performing Principal Component Analysis (PCA) on the calibration portion of the Pilot Tone signal prior to the calculation of the demixing matrix. This is preferably done in order to whiten the signal components of the Pilot Tone signals, wherein the whitened components of the Pilot Tone signal have unit variance. Preferably, the PCA is performed prior to ICA, in particular a PCA is first performed on all the signal components of the Pilot Tone signal. Thereby, the principal/orthogonal components can be identified, which leads to a reduction in dimensionality. For example, from the original 64 signal components corresponding to the channels, PCA can derive a reduced number, e.g. 20, principal components. Thus, the PCA is used as a pre-stage to the ICA, to create a reduced number of channels. The ICA is then performed on the reduced number of channels.

In a preferred embodiment, the method provides a step of displaying the filtered movement signal in particular together with information on the physiological phases and/or time points within the cyclical movement. Thus, the filtered movement signal is rendered as a graph of signal intensity over time for one or several heartbeats, and shown on e.g. a computer display in a form that a user can monitor the cardiac movement, and may thus check whether the parameters of the scan of medical image data need to be adjusted.

For monitoring purposes, the delay introduced by higher order digital filters is negligible. Hence, fast visual feedback of the filtered movement signal (the cardiac component trace) can be provided to the user in an online display. The incoming raw data is preferably bandpass filtered to remove both noise and any remnants of the respiratory component still present in the calculated cardiac component.

If model based segmentation of the cardiac trace is available, in addition to displaying the real-time cardiac component trace, a single and/or average cardiac cycle can be displayed in a user interface together with the segmented physiological phases or time points. Possible methods for visualization have been detailed in DE 10 2015 224 162 A1 and are incorporated herein by reference.

Thus the invention preferably provides a method to visualize the cardiac component trace in real-time, for quality check and patient supervision. In preferred embodiments, this is done by bandpass-filtering the cardiac component and displaying the cardiac component in a suitable image update rate, e.g. displaying 3-8 cardiac cycles in a row and overwriting them on a rolling base.

The cardiac component trace can also be encoded in the DICOM data e.g. as an image overlay and/or as grayscale image content, for further post processing. Alternatively, in the new DICOM format, the cardiac component trace could be saved as a 1D signal. The triggers used could also be stored in this way.

Preferably, the movement signal or the filtered movement signal is provided and may be saved in a computer-readable file. This file may be stored on a digital storage medium. The movement signal or the filtered movement signal may also sent over the internet and used/stored elsewhere.

In some embodiments, the filtered movement signal comprises further features, in particular information on the position of important time points within the cyclical movement. Further features may help a user or the method to find characteristic points in the cyclical movement, for example the onset of systole of the heart.

The filtered movement signal is derived from and/or directly describes the mechanical activity of the moving part of the human or animal body. Thus, the filtered movement signal is not directly related to the electrical activity (such as the ECG) but has a more direct correspondence to the actual state of contraction of the heart.

The invention is further directed to a computer program comprising program code which induces a computer to perform the method as described, when the program code is executed on the computer. The computer program can be started and ended by a user. Furthermore several input parameters can be entered by a user to optimize the output of the method.

The invention is further directed to a digital storage medium comprising the program code as described. The digital storage medium can be in form of a hard drive, like a magnetic hard disk or a solid state drive, or in form of a portable storage medium like a CD, DVD or USB-Stick, or in form of a network storage medium, like a NAS-storage or a cloud storage.

The invention is further directed to a control unit adapted for performing the method as described, wherein the control unit may be part of a computer and/or part of a magnetic resonance machine.

Preferred embodiments of the invention shall now be described with reference to the appended drawings, in which:
- Fig. 1: shows a schematic flow diagram of an embodiment of the inventive method.
- Fig. 2: shows an example of the several signal components received by the receive channels over a mean cardiac cycle (dashed lines) and the cardiac component selected therefrom by ICA (solid line).
- Fig. 3: shows an example of a cardiac component trace over one cardiac cycle, and its 1st and 2nd derivative.
- Fig. 4: shows a schematic spectral analysis of a band-pass filtered cardiac component trace (0.5Hz - 4Hz).
- Fig. 5: shows a schematic Bandpass-filtered cardiac component trace and corresponding ECG trace, wherein the Triggers (vertical dashed lines) were extracted from the ECG.
- Fig. 6: shown an MR-scanner in a schematic view.

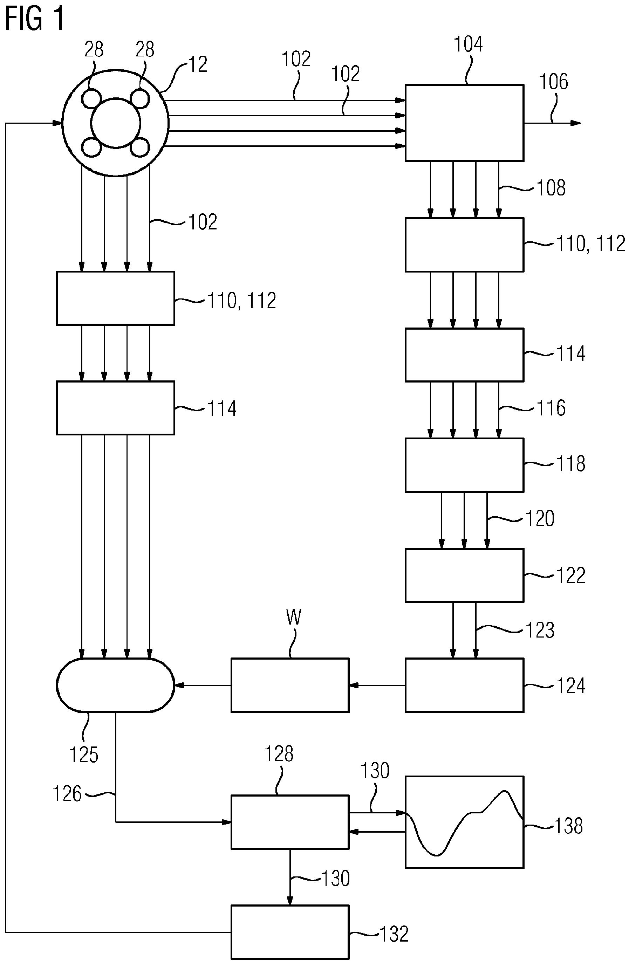

In the following and with reference to Fig. 1, we shall give an overview of an embodiment of the inventive method. In the example, according to the invention, a Pilot Tone signal is acquired during an MR scan. The processing of the acquired signal may include the following steps:
1) Calibration step: These steps can be the same as described in the DE 10 2015 224 162 A1. The purpose of the calibration step is to determine the frequency of the Pilot Tone signal and to separate the MR imaging signal from the additional Pilot Tone signal.
2) Pre-processing step: optionally Down-sampling the Pilot Tone signal (consisting of several signal components from the several receiving coil channels) and optionally low-pass filtering or bandpass filtering to suppress unwanted signals, such as the respiratory signal, and normalizing the phases of all channels to a reference phase.
3) Processing step: Calculating the demixing matrix W separating the cardiac component by applying an independent component analysis (ICA), in particular from a short calibration scan, and applying the demixing matrix on incoming data.
4 a) Filtering/triggering step: For real-time applications, denoising of the cardiac component and feature detection to enable triggering on an arbitrarily positioned predefined point in the cardiac cycle.
4 b) Filtering/post-processing step: For retrospective applications, retrospective processing of the cardiac component and the feature extraction.
5) Visualization step: Optionally, real-time visualization of the filtered movement signal, i.e. the processed cardiac component.

A flow diagram of this method in more detail is shown in fig. 1. The MR scanner 12 including a receiver coil arrangement 28 with (in this schematic example) four coils/channels is shown on the top left. When the acquisition starts, the receiver coil arrangement acquires a signal 102 having 4 signal components, which is first subjected to a calibration step 104. In useful embodiments, the absolute frequency of the Pilot Tone signal is determined in this step, and stored for use in further measurements. Optionally, a model for the expected complex navigator signal may be computed based on the calibrated absolute frequency and the knowledge of the receiver mixing frequency of the current scan/readout. The complex Pilot Tone (navigator) signal amplitude and phase may then be determined for each coil element by complex multiplication with the complex conjugated model. Then the modelled Pilot Tone may be subtracted from the incoming MR signal 102 to obtain clean MR data 106. The MR data 106 is further processed to produce MR image data, as is known in the art.

The Pilot Tone signal 108 comprising the 4 signal components is optionally pre-processed by low-pass or bandpass filtering 110 (to avoid aliasing of high-frequency noise), followed by down-sampling 112. This is because the MR signal is acquired at a very high sampling rate, which is not required for the analysis of cardiac motion. The pre-processing in optional because it increases SNR (signal to noise ratio) but at the cost of additional time delay.

The pre-processed signal is further subjected to a normalization step 114, in which the phases of all channels are normalised to a reference phase. The phase normalisation may be achieved by multiplying with the complex conjugate of the the reference channel, i.e. one of the channels is selected as the reference channel. The normalised, complex Pilot Tone signals 116 are then further processed to separate the various motion components modulating the Pilot Tone signal. This is done first by Principle Component Analysis 118, in which the largest principle components 120 are extracted, as described above. Only the largest principle components are then subjected to independent component analysis 122. Through the ICA the different components 123 of the Pilot Tone signals are separated. Typically a further reduction in dimensionality occurs, as schematically indicated in the drawing, i.e. three components 120 are reduced to two components 123, e.g. for respiratory motion and cardiac motion. The selection of the cardiac component from the independent components 123 is done in step 124. The step 124 is preferably done automatically, e.g. by calculating the signal energy in the cardiac motion band for each independent component, compared to the signal energy in other frequency bands, and selecting the component with the highest relative signal energy in the cardiac motion band. Alternatively, the degree of correlation of each signal component with a typical cardiac component trace may be calculated. Once the correct independent component representing the cardiac motion has been selected, the demixing matrix W can be automatically calculated. The demixing matrix W may correspond to a linear combination of the signal components 102/116 of the several receiver channels.

The demixing matrix W is then stored and applied to the incoming further Pilot Tone signal data 102. In some applications, the incoming data 102 may first be subjected to low-pass filtering and down-sampling 110/112, as well as phasenormalization 114. The normalised complex samples are then multiplied with the demixing matrix W in step 125 to obtain the at least one selected independent component, in particular the cardiac component 126. The signal representing the cardiac movement (movement signal) 126 is then subjected to a filter 128 as described above. In some embodiments, the filter is first trained on a calibration portion of the movement signal. The above-described adaptive filters like the Kalman Filters and Switched Kalman Filters need some time to converge, thus a calibration is useful to ensure fast convergence, but not absolutely necessary. In other applications, the filter 128 adapts over time to the incoming movement signal 126 and does not require a calibration.

Steps 104-124 are preferably carried out on a calibration portion of a Pilot Tone signal, which may be acquired prior to the MR acquisition, or during a phase of the MR examination in which the parameters for the MR examination are selected by the operator, such as the field of view and the type of measurement. Thereby, the MR examination time is not prolonged by the determination of the demixing matrix.

The filtered movement signal 130 can then be visualized on a screen 38. This may be done continually, so that the user may monitor the patient's heart activity. Also, trigger points may be selected on a user-interface 38. From the filtered movement signal or filtered cardiac component 130, trigger points 132 may be extracted, preferably this is done automatically by the filtering step 128. The trigger points 132 may be used in real-time for triggering the MR scan occurring in the MR scanner 12.

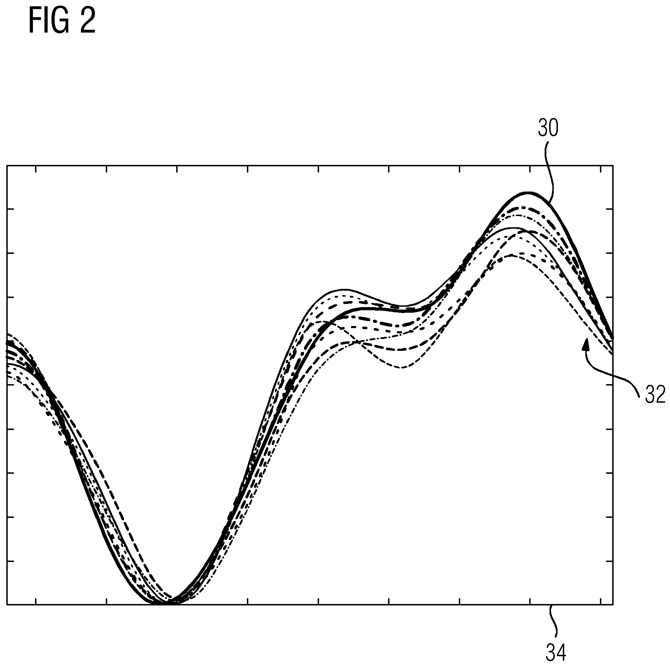

Fig. 2 shows an example of the several signal components 32 (in dashed lines) averaged over several cardiac cycles, as well as the cardiac component extracted by ICA 30 in solid line. The signal intensity 36 is plotted versus time 34.

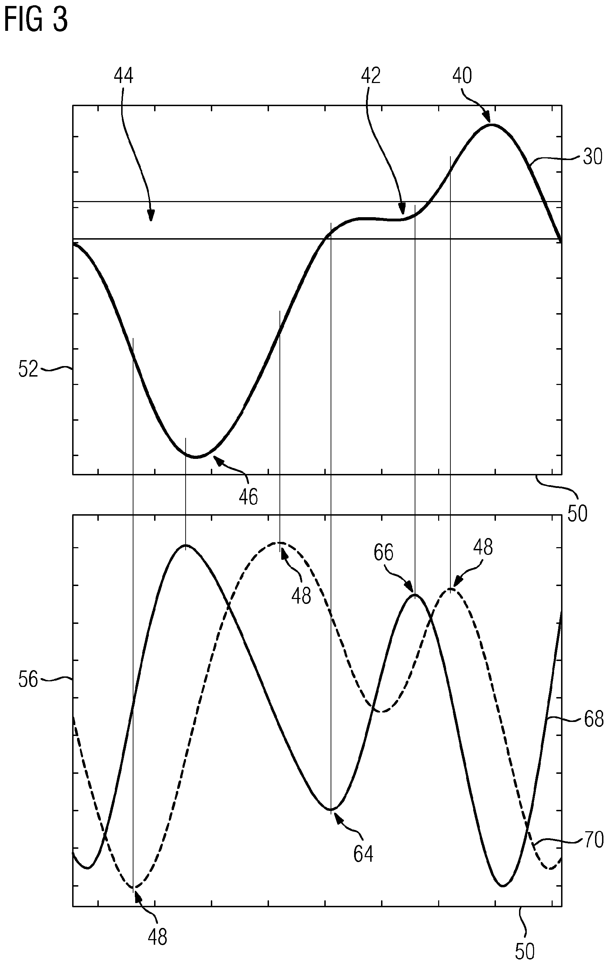

The cardiac component trace 30 is filtered as described above, e.g. by a switched Kalman filter based on a model generated by analysis of the cardiac component trace acquired during the calibration phase. The filtered cardiac component trace 30 is shown again in the top graph of Fig. 3, in a plot of amplitude 52 in arbitrary units versus time 50. In the bottom part of the graph, the first derivative 70 (in dashed line) and second derivative 68 are also shown in arbitrary units 56 plotted against time 50. From the filtered cardiac component trace, the following points of interest can be derived: The minimum of the cardiac component trace 46 indicates end-systole, i.e. the maximum contraction and resting phase. The maximum of the cardiac component 40 indicates end-diastole, i.e. the physiological phase of maximum expansion of the heart during the resting phase. The plateau 42 can be associated with the mid-diastolic phase, in which the ventricle is relaxed, i.e. a resting phase. The area 44 indicates the signal level for R wave occurrence, and may be used in a threshold trigger. The minima 48 and maxima 48 of the first derivative 70 of the cardiac component indicate the times of maximum velocity. The minimum 64 and the maximum 66 of the second derivative 68 indicate the start and end of the mid-diastolic phase.

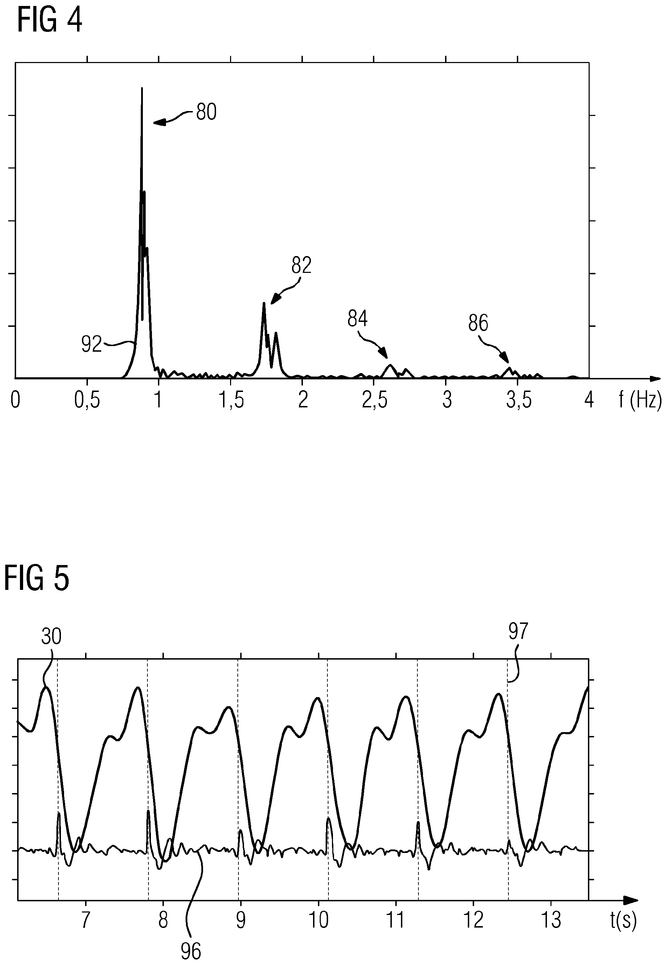

Fig. 4 shows a spectral analysis of a band-pass filtered cardiac component trace in the frequency range of 0.5 to 4 Hz. One can see that the cardiac component 92 has a main peak 80 at the base frequency corresponding to the heart rate. The first harmonic 82, the second harmonic 84 and the third harmonic 86 can also be resolved, showing systole-diastole dynamics. The splitting and broadening of the peaks is due to varying heart rate during the 90 seconds acquisition. From the spectral analysis, amplitude and phase information can be extracted using Fourier synthesis, a time-domain model can then be calculated and fed to e.g. an extended Kalman filter.

Fig. 5 is an illustration of a possible visualisation step. In this figure, the cardiac component trace 30 is plotted over 6 cardiac cycles against time, wherein the cardiac component trace is shown over a time span of about 7 seconds. The cardiac component trace 30 has been band-pass filtered before. A corresponding ECG trace 96 is also plotted, where the respective R waves are shown as dashed lines 97.

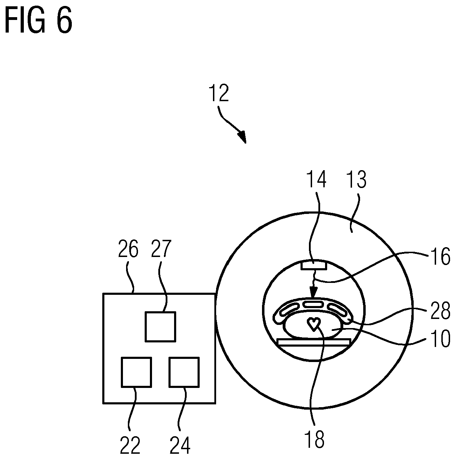

Fig. 6 finally shows a schematic MR scanner 12. The MR-scanner 12 includes a main magnet 13 and a control unit 24, by which the data acquisition of the MR scanner 12 can be controlled. The control unit 24 can be part of a computer device 26. The computer device can also include a digital storage medium 22 and a User interface 27 including e.g. a display, a keyboard, mouse, touch screen or such like. A patient 10 may be examined, in particular in order to perform MR imaging of the heart 18.

In order to provide the movement signal, a pilot tone signal 16 is emitted by a pilot tone emitter 14, which may be a separate RF source. Preferably, the pilot tone emitter 14 is positioned close to the heart, e.g. strapped to the local coil 28 or included in the coil. The pilot tone signal is modulated by the movement of the heart 18 and the lung (not shown).

The (modulated) pilot tone signal is received by the receiver coil arrangement 28, which is preferably a local coil 28, such as a head coil or chest array coil, but may also be the body coil.

### Literature

[1] http://en.wikipedia.org/wiki/Independent_component_analysis
[2] http://en.wikipedia.org/wiki/Principal_component_analysis
[3] https://en.wikipedia.org/wiki/Eigendecomposition_of_a_matrix
[4] https://en.wikipedia.org/wiki/Singular_value_decomposition
[5] https://en.wikipedia.org/wiki/Least_mean_squares_filter
[6] https://en.wikipedia.org/wiki/Kalman_filter
[7] https://en.wikipedia.org/wiki/Extended_Kalman_filter
[8] https://en.wikipedia.org/wiki/Hidden_Markov_model
[9] Pfanner, F., Allmendinger, T., Bohn, B., Flohr, T. and KachelrieB, M. (2014), Monitoring cardiac motion in CT using a continuous wave radar embedded in the patient table. Med. Phys., 41: n/a, 081908. doi:10.1118/1.4886056
[10] Pfanner, F., Maier, J., Allmendinger, T., Flohr, T. and Kachelrieß, M. (2013), Monitoring internal organ motion with continuous wave radar in CT. Med. Phys., 40: n/a, 091915. doi:10.1118/1.4818061
[11] https://en.wikipedia.org/wiki/Infomax
[12] https://en.wikipedia.org/wiki/FastICA
[13] http://mlsp.umbc.edu/ica ebm.html
[14] Schroeder, L., Wetzl, J., Maier, A., Rehner, R., Fenchel, M., Speier, P. Two-Dimensional Respiratory-Motion Characterization for Continuous MR Measurements Using Pilot Tone Navigation, Proceedings of the 24th Annual Meeting of the ISMRM (ISMRM 2016) (24th Annual Meeting of the ISMRM (ISMRM 2016)), Singapur, 7.-13.5.2016, pp. 3103, 2016
[15] Wetzl, J., Schroeder, L., Forman, C., Lugauer, F., Rehner, R., Fenchel, M., Maier, A., Hornegger, J., Speier, P. Feasibility Study: Free-Breathing 3-D CINE Imaging with Respiratory Gating Based on Pilot Tone Navigation, Proceedings of the 24th Annual Meeting of the ISMRM (ISMRM 2016) (24th Annual Meeting of the ISMRM (ISMRM 2016)), Singapur, 7.-13.5.2016, pp. 2613, 2016
[16] Schroeder, L., Wetzl, J., Maier, A., Lauer, L., Bollenbeck, J., Fenchel, M., Speier, P. A Novel Method for Contact-Free Cardiac Synchronization Using the Pilot Tone Navigator, Proceedings of the 24th Annual Meeting of the ISMRM (ISMRM 2016) (24th Annual Meeting of the ISMRM (ISMRM 2016)), Singapur, 7.-13.5.2016, pp. 410, 2016
[17] Johnson, C. C., & Guy, A. W. (1972). Nonionizing Electromagnetic Wave Effects in Biological Materials and Systems. Proceedings of the IEEE, 60(6), 692-718.
[18] Kim, S., Paul, A. S., Wan, E. A., & Mcnames, J. (2010). Multiharmonic Frequency Tracking Method Using The Sigma-Point Kalman Smoother. EURASIP Journal on Advances in Signal Processing, 2010. https://doi.org/10.1155/2010/467150

## Claims

1. A method for generating a movement signal of a part (18) of the human or animal body, of which at least a portion is undergoing a cyclical movement, in particular a cardiac movement, the method comprising the steps:
a. Providing a Pilot Tone signal (102) acquired during a Magnetic Resonance scan from the body part by a magnetic resonance receiver coil arrangement (28) comprising several channels, wherein the Pilot Tone signal is a frequency signal outside the receive bandwidth of the Magnetic Resonance scan of the body part, wherein the Pilot Tone signal comprises several signal components (102) associated with the several channels;
b. From a calibration portion of the Pilot Tone signal (102), calculating a demixing matrix (W) by means of an Independent Component Analysis (ICA) algorithm (122), wherein the demixing matrix (W) calculates the independent components (123) from the several signal components (108),
c. Selecting (124) the independent component corresponding to one particular movement type, in particular the cardiac movement,
d. Applying the demixing matrix (W) to the further portions of the Pilot Tone signal(102) to obtain at least one movement signal (126) representing the one particular movement type, in particular the cardiac movement,
e. Applying an adaptive or stochastic or model-based filter (128) to the at least one signal (126) representing the one particular movement type, in particular the cardiac movement, to obtain a filtered movement signal (30, 130).

2. The method of claim 1, comprising a step of training or adapting the adaptive or stochastic or model-based filter to the selected independent component, in particular the independent component (126) from the calibration portion.

3. The method of one of the preceding claims, wherein the adaptive or stochastic or model-based filter (128) is a Kalman Filter, or an Extended Kalman filter, or is a Switched Kalman Filter, wherein the Switched Kalman Filter switches between several models during various phases of the cyclical movement.

4. The method of one of the preceding claims, wherein the adaptive or stochastic or model-based filter (128) uses a Hidden Markov Model.

5. The method of one of the preceding claims, wherein the adaptive or stochastic or model-based filter (128) is trained to the selected independent component in the frequency and/or in the time domain.

6. The method of one of the preceding claims, wherein the adaptive or stochastic or model-based filter (128) automatically segments the movement signal into two or more sections (40, 42, 48, 64, 66) corresponding to two or more physiological phases of the cyclical movement, in particular to the phases of the cardiac movement such as systole and diastole.

7. The method of one of the preceding claims, wherein instead of the stochastic or model-based filter (128), forward-backward filtering using in particular FIR or IIR digital filters is performed on the movement signal.

8. The method of one of the preceding claims, wherein the steps of applying the demixing matrix (W) and/or applying the adaptive or stochastic or model-based filter (128) are performed such that no delay is introduced between the filtered movement signal (130) and a signal comprising magnetic resonance data, acquired at the same time as the Pilot Tone signal from the body part, so that the filtered movement signal is effectively generated in real time.

9. The method of one of the preceding claims, wherein time points (132) used for triggering a scan of medical data from the part of the human or animal body, or for post-processing a scan of medical data performed during the acquisition of the Pilot Tone signal, are extracted from the filtered movement signal (30, 130), in particular based on properties of the curve or the parameters of the adaptive or stochastic or model-based filter.

10. The method of one of the preceding claims, comprising the further step of performing Principal Component Analysis (118) on the calibration portion of the Pilot Tone signal (116) prior to the calculation of the demixing matrix, in order to whiten the signal components of the Pilot Tone signals, wherein the whitened components of the pilot signal have unit variance.

11. The method of one of the preceding claims, wherein prior to the calculation of the demixing matrix and/or prior to the application of the demixing matrix to the further portions of the Pilot Tone signal, the Pilot Tone signal is down sampled (110) and/or low-pass filtered (112).

12. A computer program comprising program code, which induces a computer to perform the method according to one of the preceding claims, when the program code is executed on the computer.

13. A digital storage medium (22) comprising the program code of claim 12.

14. A control unit (24) adapted for performing the method according to one of claims 1 to 11, wherein the control unit may be part of a computer (26) and/or part of a magnetic resonance scanner (12).

## Patentansprüche

1. Verfahren zur Erzeugung eines Bewegungssignals eines Teils (18) des menschlichen oder tierischen Körpers, von dem mindestens ein Anteil eine zyklische Bewegung durchläuft, insbesondere eine Herzbewegung, wobei das Verfahren die Schritte umfasst:
a. Bereitstellen eines Pilottonsignals (102), das während eines Magnetresonanzscans von dem Körperteil durch eine Magnetresonanzempfängerspulenanordnung (28), die mehrere Kanäle umfasst, erfasst wurde, wobei das Pilottonsignal ein Frequenzsignal außerhalb der Empfangsbandbreite des Magnetresonanzscans des Körperteils ist, wobei das Pilottonsignal mehrere Signalkomponenten (102) umfasst, die mit den mehreren Kanälen assoziiert sind;
b. Berechnen einer Entmischungsmatrix (W) aus einem Kalibrierungsanteil des Pilottonsignals (102) mittels eines Algorithmus (122) zur unabhängigen Komponentenanalyse (ICA), wobei die Entmischungsmatrix (W) die unabhängigen Komponenten (123) aus den mehreren Signalkomponenten (108) berechnet,
c. Auswählen (124) der unabhängigen Komponente, die einem speziellen Bewegungstyp entspricht, insbesondere der Herzbewegung,
d. Anwenden der Entmischungsmatrix (W) auf die weiteren Anteile des Pilottonsignals (102), um mindestens ein Bewegungssignal (126) zu erhalten, welches den einen speziellen Bewegungstyp repräsentiert, insbesondere die Herzbewegung,
e. Anwenden eines adaptiven oder stochastischen oder modellbasierten Filters (128) auf das mindestens eine Signal (126), welches den einen speziellen Bewegungstyp repräsentiert, speziell die Herzbewegung, um ein gefiltertes Bewegungssignal (30, 130) zu erhalten.

2. Verfahren nach Anspruch 1, umfassend einen Schritt des Trainierens oder Adaptierens des adaptiven oder stochastischen oder modellbasierten Filters auf die ausgewählte unabhängige Komponente, insbesondere die unabhängige Komponente (126) aus dem Kalibrierungsanteil.

3. Verfahren nach einem der vorhergehenden Ansprüche, wobei das adaptive oder stochastische oder modellbasierte Filter (128) ein Kalman-Filter oder ein erweitertes Kalman-Filter oder ein geschaltetes Kalman-Filter ist, wobei das geschaltete Kalman-Filter während verschiedenen Phasen der zyklischen Bewegung zwischen mehreren Modi schaltet.

4. Verfahren nach einem der vorhergehenden Ansprüche, wobei das adaptive oder stochastische oder modellbasierte Filter (128) ein Hidden-Markov-Modell verwendet.

5. Verfahren nach einem der vorhergehenden Ansprüche, wobei das adaptive oder stochastische oder modellbasierte Filter (128) in der Frequenz- und/oder in der Zeitdomäne auf die ausgewählte unabhängige Komponente trainiert wird.

6. Verfahren nach einem der vorhergehenden Ansprüche, wobei das adaptive oder stochastische oder modellbasierte Filter (128) das Bewegungssignal automatisch in zwei oder mehr Segmente (40, 42, 48, 64, 66) entsprechend zwei oder mehr physiologischen Phasen der zyklischen Bewegung segmentiert, insbesondere in die Phasen der Herzbewegung, wie Systole und Diastole.

7. Verfahren nach einem der vorhergehenden Ansprüche, wobei anstelle des stochastischen oder modellbasierten Filters (128) Vorwärts-rückwärts-Filtern unter Verwendung von speziellen digitalen FIR- oder IIR-Filtern mit dem Bewegungssignal durchgeführt wird.

8. Verfahren nach einem der vorhergehenden Ansprüche, wobei die Schritte des Anwendens der Entmischungsmatrix (W) und/oder des Anwendens des adaptiven oder stochastischen oder modellbasierten Filters (128) so durchgeführt werden, dass zwischen dem gefilterten Bewegungssignal (130) und einem Signal, das Magnetresonanzdaten umfasst, die zur gleichen Zeit wie das Pilottonsignal von dem Körperteil erfasst wurden, keine Verzögerung eingebracht wird, so dass das gefilterte Bewegungssignal effektiv in Echtzeit erzeugt wird.

9. Verfahren nach einem der vorhergehenden Ansprüche, wobei Zeitpunkte (132), die zum Auslösen eines Scans von medizinischen Daten von dem Teil des menschlichen oder tierischen Körpers oder zur Nachverarbeitung eines Scans von medizinischen Daten verwendet werden, der während der Erfassung des Pilottonsignals durchgeführt wurde, aus dem gefilterten Bewegungssignal (30, 130) extrahiert werden, insbesondere basierend auf Eigenschaften der Kurve oder den Parametern des adaptiven oder stochastischen oder modellbasierten Filters.

10. Verfahren nach einem der vorhergehenden Ansprüche, umfassend den weiteren Schritt des Durchführens von Hauptkomponentenanalyse (118) mit dem Kalibrierungsanteil des Pilottonsignals (116) vor der Berechnung der Entmischungsmatrix, um die Signalkomponenten des Pilottonsignals Whitening zu unterziehen, wobei die Whitening unterzogenen Komponenten des Pilotsignals eine Einheitsvarianz haben.

11. Verfahren nach einem der vorhergehenden Ansprüche, wobei das Pilottonsignal vor der Berechnung der Entmischungsmatrix und/oder vor der Anwendung der Entmischungsmatrix auf die weiteren Anteile des Pilottonsignals Downsampling (110) und/oder Tiefpassfiltern (112) unterzogen wird.

12. Computerprogramm, welches Programmcode umfasst, der einen Computer dazu bringt, das Verfahren gemäß einem der vorhergehenden Ansprüche durchzuführen, wenn der Programmcode auf dem Computer ausgeführt wird.

13. Digitales Speichermedium (22), umfassend den Programmcode nach Anspruch 12.

14. Steuereinheit (24), die zum Durchführen des Verfahrens nach einem der Ansprüche 1 bis 11 vorgesehen ist, wobei die Steuereinheit Teil eines Computers (26) und/oder Teil eines Magnetresonanzscanners (12) sein kann.

## Revendications

1. Procédé de création d'un signal de mouvement d'une partie (18) du corps humain ou animal, dont une partie subit un mouvement cyclique, en particulier un mouvement cardiaque, le procédé comprenant les stades :
a. On se procure un signal (102) de Tonalité Pilote acquis pendant une tomodensitomètrie par résonance magnétique de la partie du corps par un agencement (28) à bobine de récepteur de résonance magnétique comprenant plusieurs canaux, le signal de Tonalité Pilote étant un signal de fréquence à l'extérieur de la largeur de bande de réception du scan de résonance magnétique de la partie du corps, le signal de Tonalité Pilote comprenant plusieurs composantes (102) de signal associées aux plusieurs canaux ;
b. D'une partie d'étalonnage du signal (102) de Tonalité Pilote, on calcule une matrice (W) de démixage au moyen d'un algorithme (122) d'analyse (ICA) de composantes indépendantes, la matrice (W) de démixage calculant les composantes (123) indépendantes à partir des plusieurs composantes (108) du signal,
c. On sélectionne (124) la composante indépendante correspondant à un type particulier de mouvement, en particulier au mouvement cardiaque,
d. On applique la matrice (W) de démixage aux autres parties du signal (102) de Tonalité Pilote pour obtenir au moins un signal (126) de mouvement représentant le un type particulier de mouvement, en particulier le mouvement cardiaque,
e. On applique un filtre (128) adaptatif ou stochastique ou fondé sur un modèle au au moins un signal (126) représentant le un type particulier de mouvement, en particulier le mouvement cardiaque, pour obtenir un signal (30, 130) de mouvement filtré.

2. Procédé suivant la revendication 1, comprenant un stade d'apprentissage ou d'adaptation du filtre adaptif ou stochastique ou reposant sur un modèle à la composante indépendante sélectionnée, en particulier à la composante (126) indépendante de la partie d'étalonnage.

3. Procédé suivant l'une des revendications précédentes, dans lequel le filtre (128) adaptatif ou stochastique ou reposant sur un modèle est un filtre de Kalman ou un filtre de Kalman étendu ou un filtre de Kalman commuté, le filtre de Kalman commuté commutant entre plusieurs modèles pendant diverses phases du mouvement cyclique.

4. Procédé suivant l'une des revendications précédentes, dans lequel le filtre (128) adaptatif ou stochastique ou reposant sur un modèle utilise un modèle de Markov caché.

5. Procédé suivant l'une des revendications précédentes, dans lequel le filtre (128) adaptatif ou stochastique ou reposant sur un modèle est adapté par apprentissage à la composante indépendante sélectionnée dans le domaine fréquentiel et/ou dans le domaine temporel.

6. Procédé suivant l'une des revendications précédentes, dans lequel le filtre (128) adaptatif ou stochastique ou reposant sur un modèle segmente automatiquement le signal de mouvement en deux ou plusieurs parties (40, 42, 48, 64, 66) correspondant à deux ou plusieurs phases physiologiques du mouvement cyclique, en particulier aux phases du mouvement cardiaque telles que la systole et la diastole.

7. Procédé suivant l'une des revendications précédentes, dans lequel au lieu du filtre (128) stochastique ou reposant sur un modèle, on effectue un filtrage vers l'avant - vers l'arrière en utilisant en particulier des filtres numériques FIR ou IIR sur le signal de mouvement.

8. Procédé suivant l'une des revendications précédentes, dans lequel on effectue les stades d'application de la matrice (W) de démixage et/ou d'application du filtre (128) adaptatif ou stochastique ou reposant sur un modèle, de manière à ne pas introduire de retard entre le signal (130) de mouvement filtré et un signal comprenant une donnée de résonance magnétique acquis en même temps que le signal de Tonalité Pilote de la partie du corps, de manière à ce que le signal de mouvement filtré soit créé effectivement en temps réel.

9. Procédé suivant l'une des revendications précédentes, dans lequel on extrait des points (132) dans le temps, utilisés pour déclencher un scan de donnée médicale de la partie du corps humain ou animal ou pour post-traiter un scan de donnée médicale effectué pendant l'acquisition du signal de Tonalité Pilote, du signal (30, 130) de mouvement filtré, en particulier sur la base de propriétés de la courbe ou des paramètres du filtre adaptatif ou stochastique ou reposant sur un modèle.

10. Procédé suivant l'une des revendications précédentes, comprenant le stade supplémentaire dans lequel on effectue une analyse (118) de Composante Principale sur la partie d'étalonnage du signal (116) de Tonalité Pilote, avant le calcul de la matrice de démixage, afin de blanchir les composantes des signaux de Tonalité Pilote, les composantes blanchies du signal pilote ayant une variance unitaire.

11. Procédé suivant l'une des revendications précédentes, dans lequel, avant le calcul de la matrice de démixage et/ou avant l'application de la matrice de démixage aux autres parties du signal de Tonalité Pilote, on échantillonne (110) vers le bas le signal de Tonalité Pilote et/ou on le filtre (112) passe bas.

12. Programme d'ordinateur comprenant un code de programme, qui fait qu'un ordinateur effectue le procédé suivant l'une des revendications précédentes, lorsque le code de programme est exécuté sur l'ordinateur.

13. Support (22) numérique de mise en mémoire, comprenant le code de programme de la revendication 12.

14. Unité (24) de commande conçue pour effectuer le procédé suivant l'une des revendications 1 à 11, dans lequel l'unité de commande peut faire partie d'un ordinateur (26) et/ou faire partie d'un tomodensitomètre (12) par résonance magnétique.
